# EUROPEAN PATENT APPLICATION

(11) **EP 0 818 890 A2**
(43) Date of publication of application: **14.01.1998**
(21) Application number: 97304714.5
(22) Date of filing: 30.06.1997
(51) Int. Cl.: H03K 17/22

(54) **Power on reset circuit**

(30) Priority: 13.07.1996 GB 9614799
(71) Applicant: PLESSEY SEMICONDUCTORS LIMITED, Swindon, Wiltshire SN2 2QW (GB)
(72) Inventor: Teutsch, Gert, Muenchen (DE)
(74) Representative: Hoste, Colin Francis

(57) **Abstract**

In an integrated circuit incorporating a plurality of flip-flops, one of the flip-flops is dedicated to providing a power-on reset pulse. The two outputs of this flip-flop are coupled to inputs of an exclusive OR gate, such that on power-up, as soon as the flip-flop is energised sufficiently to take up one or other state, the exclusive OR gate provides an output from which a reset pulse can be derived.

## Description

The present invention relates to power-on reset circuits.

Very often in digital integrated circuits a power-on reset signal is required to establish a defined logic state at power-on. This is particularly so in integrated circuits incorporating flip-flops, which would otherwise latch in an unpredictable state. The reset signal may be derived from circuitry outside the integrated circuit or from a special reset circuit built in to the integrated circuit.

Known reset circuits make use of comparators and voltage reference sources to determine when the supply voltage is high enough for flip-flops to set or reset reliably. For application specific integrated circuits or for gate arrays the required reference voltage sources are not generally available.

In accordance with one aspect of the present invention a power-on reset circuit for an integrated circuit comprises a sensor flip-flop and exclusive OR gating means arranged to initiate a reset signal when the potentials at the outputs of the sensor flip-flop diverge.

In accordance with another aspect of the present invention a power-on reset circuit for an integrated circuit incorporating a plurality of flip-flops comprises a sensor flip-flop formed in said integrated circuit and having two inputs and two outputs, the two outputs being connected to respective inputs of exclusive OR gating means arranged to initiate a reset signal when the potentials at the outputs of said sensor flip-flop diverge.

Preferably the two inputs of said sensor flip-flop are connected together and to an intermediate point in a potential divider path connected between supply lines of said integrated circuit.

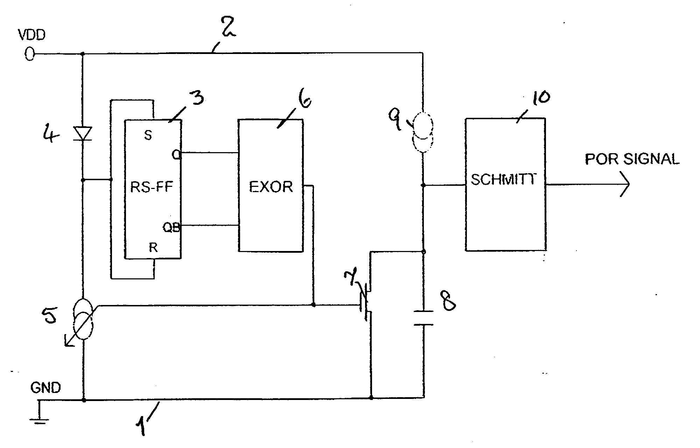

A power-on reset circuit in accordance with the present invention will now be described by way of example with reference to the accompanying drawing, which shows the circuit schematically.

Referring to the drawing, in an integrated circuit incorporating a plurality of flip-flop (not shown) which are energised by way of supply lines 1 and 2, a sensor flip-flop 3, which may be of the same basic structure as the plurality of flip-flops and which is energised from the supply lines 1 and 2, has its R and S inputs connected together and to an intermediate point in a potential divider path comprising a diode 4 and a current source 5.

The Q and Q bar outputs of the flip-flop 3 are connected to the inputs of an exclusive OR gate 6, the outputs of this gate being connected to the gate electrode of a field effect transistor 7 whose source-drain path is connected across a capacitor 8. The capacitor 8 is connected in series with a current source 9 between supply lines 1 and 2, the node between the capacitor 8 and the current source 9 being connected to an input of a Schmitt trigger circuit 10.

While the integrated circuit is unpowered the outputs of the flip-flop 3 are both at effectively zero volts. As the potential difference between the supply lines 1 and 2 increases at power-on a point is reached where the difference is sufficient for the flip-flops in the integrated circuit to operate, although with its inputs both connected to the potential divider, and therefore at the diode voltage below VDD, the flip-flop 3 tends not to latch until the supply voltage is higher than that needed for the other flip-flops.

When the flip-flop 3 latches its outputs diverge in potential and the exclusive OR circuit 6 operates to bias off the transistor 7, thereby allowing the capacitor 8 to charge by way of the current source 9. While the capacitor 8 is charging the Schmitt trigger circuit 10 provides an output pulse to reset the integrated circuit.

Since the sensor flip-flop 3 is part of the integrated circuit the working threshold for the power-on reset automatically adapts to variations of operating temperature or chip technology parameters.

## Claims

1. A power-on reset circuit for an integrated circuit, comprising a sensor flip-flop and exclusive OR gating means arranged to initiate a reset signal when the potentials at the outputs of the sensor flip-flop diverge.

2. A power-on reset circuit for an integrated circuit incorporating a plurality of flip-flops, comprising a sensor flip-flop formed in said integrated circuit and having two inputs and two outputs, the two outputs being connected to respective inputs of exclusive OR gating means arranged to initiate a reset signal when the potentials at the outputs of said sensor flip-flop diverge.

3. A power-on reset circuit in accordance with Claim 2 wherein the two inputs of said sensor flip-flop are connected together and to an intermediate point in a potential divider path connected between supply lines of said integrated circuit.

4. A power-on reset circuit in accordance with any preceding claim wherein an output of said exclusive OR gating means is arranged to enable a trigger circuit to generate said reset signal.

5. A power-on reset circuit in accordance with Claim 4 wherein the trigger circuit is a Schmitt trigger circuit operable to provide said reset signal while a capacitor charges towards a supply voltage for the circuit, said output of said exclusive OR gating means being arranged to bias off a transistor switch means connected in parallel with said capacitor.
